# EUROPÄISCHE PATENTANMELDUNG

(11) **EP 2 166 569 A1**
(43) Veröffentlichungstag der Anmeldung: **24.03.2010**
(21) Anmeldenummer: 08164816.4
(22) Anmeldetag: 22.09.2008
(51) Int. Cl.: H01L 23/467, H01L 23/473

(54) **Kühlvorrichtung für ein Leistungsbauelement**

(71) Anmelder: ABB Schweiz AG, 5400 Baden (CH)
(72) Erfinder: Knapp, Wolfgang, CH-5600, Lenzburg (CH)
(74) Vertreter: ABB Patent Attorneys

(57) **Zusammenfassung**

Die Erfindung betrifft ein Kühlelement (6) zum Abführen von Wärme von einem Wärme erzeugenden Bauelement (2), insbesondere einem leistungselektronischen Bauelement, wobei das Kühlelement mehrere gegeneinander verschwenkbare Kühlabschnitte (61) mit jeweils einer Wärme aufnehmenden Teilfläche aufweist, wobei die Kühlabschnitte (61) gegeneinander verschwenkbar sind, so dass sich die Teilflächen an eine unebene Wärmeabführungsfläche (52) des Wärme erzeugenden Bauelements (2) anpassen. Das Kühlelement (6) kann in einer Kühlvorrichtung (3) angeordnet sein, in der es flächig gegen die Wärmeabführungsfläche (52) gedrückt wird.

## Beschreibung

### Technisches Gebiet

Die Erfindung betrifft Kühlvorrichtungen für Wärme abgebende Bauelemente, insbesondere leistungselektronische Module mit einer zu kühlenden Grundplatte.

### Stand der Technik

Das Kühlen von Bauelementen erfolgt in der Regel dadurch, dass das Bauelement in einem Bereich mit einer Wärme abführenden Kühlvorrichtung verbunden wird. Dabei wird darauf geachtet, dass der Wärmewiderstand zwischen dem Bauelement und dem Kühlelement möglichst gering ist. Üblicherweise werden das Bauelement und die Kühlvorrichtung dazu mit ebenen oder zueinander komplementären Flächen versehen, die gegeneinander gepresst werden, um einen möglichst flächigen Kontakt und somit einen geringen Wärmewiderstand zwischen dem Bauelement und der Kühlvorrichtung zu erhalten.

Leistungselektronische Bauelemente weisen üblicherweise diskrete oder integrierte elektronische Bauelemente auf, die in geeigneter Weise auf einer Grundplatte befestigt sind, so dass über die Grundplatte die in den elektronischen Bauelementen erzeugte Wärme abgeleitet werden kann. Durch die starre Verbindung der elektronischen Bauelemente mit der Grundplatte kann es bei sich ändernden Temperaturen aufgrund von unterschiedlichen Wärmeausdehnungskoeffizienten von Bauelementen und Grundplatte zu Verformungen der Grundplatte kommen. Weiterhin sind bei Grundplatten, die in Schichttechnik mit verschiedenen Materialien aufgebaut sind, aufgrund der unterschiedlichen Wärmeausdehnungskoeffizienten ebenfalls Verformungen möglich. Darüber hinaus ist es auch möglich, dass die Grundplatte aufgrund ihres Herstellungsprozesses nicht vollständig eben ist.

Beim Anbringen der Kühlvorrichtung an eine entsprechende Fläche der Grundplatte ist es daher häufig der Fall, dass das Bauelement und die Kühlvorrichtung nicht vollständig flächig miteinander in Verbindung stehen, so dass die Wärmeleitung reduziert ist.

Um für diesen Fall die Wärmeleitung zwischen Bauelement und Kühlvorrichtung zu verbessern, wird zwischen der Kühlvorrichtung und dem Bauelement häufig ein Schnittstellenmaterial wie z.B. eine Wärmeleitpaste und dgl. eingebracht. Die zwischen der Kühlvorrichtung und dem Bauelement eingebrachte Wärmeleitpaste kann aufgrund der während Temperaturänderungen auftretenden Verformungen herausgepresst werden (pumpout-effect) und verschlechtert dadurch die Wärmeleitung zu der Kühlvorrichtung mit zunehmender Betriebsdauer.

Weiterhin wird häufig die Kühlvorrichtung an dem Bauelement durch Befestigungsstifte verbunden, um einen ausreichenden Anpressdruck zwischen dem Kühlelement und dem Bauelement zu bewirken. Jedoch können die Befestigungsstifte zusätzlichen Stress verursachen, der zu einer Verformung der Wärmeübertragungsfläche und zu einem Ausbilden lokaler Zwischenräume zwischen der Kühlvorrichtung und dem Bauelement führen kann.

### Darstellung der Erfindung

Es ist Aufgabe der vorliegenden Erfindung, eine Kühlvorrichtung zur Verfügung zu stellen, mit der eine verbesserte Wärmeableitung von einer Wärmeableitungsfläche eines Wärme abgebenden Bauelement erreicht werden kann. Diese Aufgabe wird durch das Kühlelement nach Anspruch 1 sowie durch die Kühlvorrichtung und Kühlanordnung gemäß den nebengeordneten Ansprüchen gelöst.

Weitere vorteilhafte Ausgestaltungen der Erfindung sind in den abhängigen Ansprüchen angegeben.

Gemäß einem ersten Aspekt ist ein Kühlelement zum Abführen von Wärme von einem Wärme erzeugenden Bauelement, insbesondere einem leistungselektronischen Bauelement vorgesehen. Das Kühlelement weist mehrere gegeneinander verschwenkbare Kühlabschnitte mit jeweils einer Wärme aufnehmenden Teilfläche auf, wobei die Kühlabschnitte gegeneinander verschwenkbar sind, so dass sich die Teilflächen an eine unebene Wärmeabführungsfläche des Wärme erzeugenden Bauelements anpassen.

Eine Idee des obigen Kühlelements besteht darin, dieses mit gegeneinander verschwenkbaren Kühlabschnitten aufzubauen, so dass sich das Kühlelement an Unebenheiten einer Wärmeabführungsfläche des Bauelementes anpassen kann, indem sich jeder einzelne Kühlabschnitt durch Ausüben eines Drucks gegen die Wärmeabführungsfläche entsprechend verschwenkt. So kann die Fläche an der die Wärmeübertragung erfolgt, gegenüber einem starren Kühlelement verbessert werden. Insbesondere kann sich das Kühlelement permanent an sich ändernde Unebenheiten anpassen.

Dies kann beispielsweise dadurch erreicht werden, indem die Kühlabschnitte über Brücken verringerten Querschnittes miteinander verbunden sind, die als Bereich dienen, an dem zwei miteinander verbundene Kühlabschnitte gegeneinander verschwenkt werden können.

Weiterhin kann das Kühlelement mit einem oder mehreren Kühlmediumkanälen durch mehrere Kühlabschnitte, durch die ein Kühlmedium leitbar ist, vorgesehen sein.

Gemäß einer Ausführungsform ist das Kühlelement mit einem ersten und einem zweiten Kühlblech aus einem metallischen Material, die flächig aufeinander gefügt sind, ausgeführt, wobei mindestens eines der Kühlbleche Vertiefungen aufweist, die beim Aufeinanderfügen in Richtung eines jeweils anderen Kühlbleches weisen, so dass an der Stelle der Vertiefung eine erhöhte Verschwenkbarkeit der zwischen den Vertiefungen gebildeten Kühlabschnitte besteht.

Weiterhin kann das erste und das zweite Kühlblech Vorsprünge aufweisen, in die Vertiefungen hineinragen, wobei die Kühlbleche so aufeinander gesetzt sind, dass die Vorsprünge der Kühlbleche gegeneinander gerichtet sind und kammartig ineinander greifen, so dass mindestens ein Vorsprung des ersten Kühlblechs zwischen zwei benachbarten Vorsprüngen des zweiten Kühlblechs angeordnet ist.

Gemäß einer Ausführungsform kann ein Vorsprung des ersten Kühlbleches mit einem entsprechenden Bereich zwischen zwei Vorsprüngen des zweiten Kühlbleches verbunden sein.

Es kann vorgesehen sein, dass das Kühlelement durch flächiges Aufeinanderfügen von einem ersten und einem zweiten Kühlblech aus einem metallischen Material gebildet ist, wobei mindestens das erste Kühlblech so geformt ist, dass es in einem Kühlmediumkanalbereich, an dem der eine oder die mehreren Kühlmediumkanäle ausgebildet sind, bezüglich seiner Grundfläche vertieft ist.

Weiterhin kann mindestens einer der Kühlmediumkanäle Abschnitte mit verschiedenen Hauptfließrichtungen von Kühlmedium aufweisen und insbesondere mäanderförmig ausgebildet sein.

Alternativ oder zusätzlich kann mindestens einer der Kühlmediumkanäle Abschnitte bezüglich der Querrichtung zu einer Hauptfließrichtung von Kühlmedium verschiedener Breite aufweisen.

Gemäß einer Ausführungsform können zwischen den Kühlmediumkanälen des Kühlelements Bereiche mit verringerter Dicke, insbesondere durchgängige Schlitze (18a, 18b) und/oder nicht-durchgängige Schnitte und/oder Prägebereiche, vorgesehen sein, um die Biegsamkeit senkrecht zu einer Flächenebene der Grundfläche des Kühlelements zu erhöhen.

Weiterhin kann mindestens einer der Bereiche mit verringerter Dicke sich in einer ersten Flächenrichtung parallel zur Hauptfließrichtung der Kühlmediumkanäle, insbesondere zwischen zwei Kühlmediumkanälen erstrecken und/oder mindestens einer der Bereiche mit verringerter Dicke sich in einer zweiten Flächenrichtung quer zur Hauptfließrichtung der Kühlmediumkanäle erstrecken.

Gemäß einem weiteren Aspekt ist eine Kühlvorrichtung zum Abführen von Wärme von einem Wärme erzeugenden Bauelement, insbesondere einem leistungselektronischen Bauelement, vorgesehen. Die Kühlvorrichtung umfasst das obige Kühlelement und eine Anpresseinrichtung zum flächigen Ausüben einer Anpresskraft auf das Kühlelement.

Weiterhin kann die Anpresseinrichtung ein elastisches Material aufweisen, das mit Hilfe einer druckausübenden Einrichtung, insbesondere einer Druckplatte, gegen das Kühlelement drückbar ist, um auf jeden Kühlabschnitt des Kühlelementes die Anpresskraft auszuüben.

Alternativ kann die Anpresseinrichtung eine Druckkammer aufweisen, die so mit dem Kühlelement verbunden ist, dass durch Einbringen eines erhöhten Druck in der Druckkammer die Anpresskraft flächig auf das Kühlelement wirkt, um auf jeden Kühlabschnitt des Kühlelementes die Anpresskraft auszuüben.

Gemäß einem weiteren Aspekt ist eine Kühlanordnung mit einem Wärme erzeugenden Bauelement und der obigen Kühlvorrichtung vorgesehen.

### Kurze Beschreibung der Zeichnungen

Bevorzugte Ausführungsformen der Erfindung werden nachfolgend anhand der beigefügten Zeichnungen näher erläutert. Es zeigen:
- Fig. 1: eine Querschnittsdarstellung einer an einem leistungselektronischen Bauelement angebrachten Kühlvorrichtung;
- Fig. 2: eine schematische Querschnittsdarstellung eines an eine unebene Wärmeabführungsfläche angepassten Kühlelementes;
- Fig. 3a: und 3b schematische Querschnittsdarstellungen von zwei möglichen Ausführungsformen eines Kühlelementes der Kühlvorrichtung der Fig. 1;
- Fig. 4a: ein erstes Kühlblech zum Aufbau eines Kühlelementes zur Verwendung in einer Kühlvorrichtung der Fig. 1 einschließlich einer Querschnittsansicht entlang der Schnittlinie A-A;
- Fig. 4b: ein Kühlelement mit dem ersten Kühlblech der Fig. 3a, das mit einem zweiten Kühlblech verbunden wird, um das Kühlelement mit Kühlmediumkanälen auszubilden, einschließlich einer Querschnittsansicht entlang der Schnittlinie B-B;
- Fig. 5a: eine Variante zur Ausbildung des ersten Kühlbleches der Fig. 4a mit einer Einbuchtung zur besseren Strömungsverteilung des Kühlmediums in den Strömungskanälen;
- Fig. 5b: eine Darstellung des Kühlmediumflusses in dem Kühlmediumkanal;
- Fig. 6: eine weitere Variante eines Kühlelement mit mäanderförmigen Kanälen für das Kühlmedium;
- Fig. 7: ein weitere Variante eines Kühlelements.

Gleiche Bezugszeichen bezeichnen Elemente gleicher oder vergleichbarer Funktion.

### Wege zur Ausführung der Erfindung

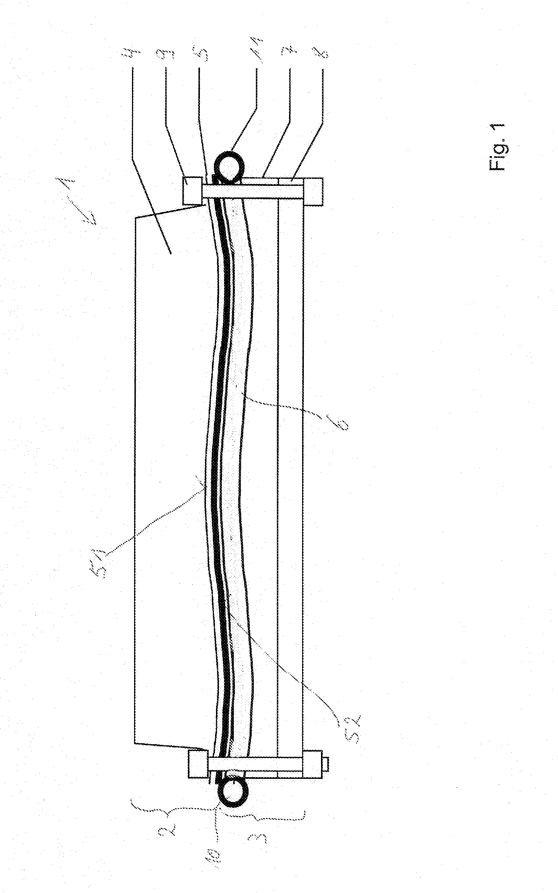

Fig. 1 zeigt eine Querschnittsdarstellung einer Kühlanordnung 1 mit einem leistungselektronischen Bauelement 2 und einer Kühlvorrichtung 3 zum Abführen von Wärme aus dem leistungselektronischen Bauelement 2. Das leistungselektronische Bauelement 2 umfasst ein Leistungsmodul 4 und eine Grundplatte 5. Das Leistungsmodul 4 ist im gezeigten Ausführungsbeispiel an einer Befestigungsfläche 51 der Grundplatte angeordnet, während eine dazu gegenüberliegende Wärmeabführungsfläche 52 zur Wärmeabführung aus dem Leistungsmodul 4 dient. Das Leistungsmodul 4 kann elektronische Bauteile wie Leistungstransistoren, integrierte Schaltungen und dergleichen aufweisen, bei deren Betrieb Wärme abgegeben wird. Diese Bauteile sind in der Regel so an der Grundplatte 5 befestigt, dass ein Großteil der abgegebenen Wärme von der Grundplatte 5 aufgenommen werden kann.

Die Kühlvorrichtung 3 umfasst ein Kühlelement 6, das verformbar ausgebildet ist. Das Kühlelement 6 wird mit Hilfe eines elastischen Materials 7, das durch eine Druckplatte 8 in Richtung der Grundplatte 5 des leistungselektronischen Bauelements 2 gedrückt wird, an die Wärmeabführungsfläche 52 der Grundplatte 5 angepresst. Durch das Anpressen verformt sich das verformbare Kühlelement 6, so dass es sich an die Form bzw. Unebenheit der Wärmeabführungsfläche 52 der Grundplatte 5 anpasst und daran angedrückt wird.

Das elastische Material 7 dient dazu, eine Kraft flächig über die gesamte Erstreckung des Kühlelementes 6 gegen die Wärmeabführungsfläche 52 auszuüben. Das elastische Material 7 kann beispielsweise ein elastisches Schaummaterial, wie z.B. Neopren oder jegliche Art elastischen Materials sein. Das elastische Material 7 kann vorzugsweise eine Wärmeleitfähigkeit aufweisen, die mindestens der Wärmeleitfähigkeit des Kühlelementes 6 entspricht, so dass eine Wärmeableitung über das Kühlelement 6 auch in Richtung der Druckplatte 5 erfolgen kann.

Anstelle des elastischen Materials 7 kann auch vorgesehen sein, den Bereich zwischen der Druckplatte 8 und dem Kühlelement 6 als abgeschlossene Druckkammer auszubilden, die mit einem komprimierbaren Gas, wie z.B. Luft, gefüllt ist. Das in der abgeschlossenen Druckkammer befindliche Gas wird komprimiert und weist einen Druck auf, der größer ist als der Umgebungsdruck. Da zwischen der Wärmeabführungsfläche der Grundplatte 5 und der entsprechenden Oberfläche des Kühlelementes 6 im Wesentlichen der Umgebungsdruck herrscht, bewirkt der erhöhte Druck in der abgeschlossenen Druckkammer zwischen der Druckplatte 8 und dem Kühlelement 6, dass sich das Kühlelement 6 verformt und an die Wärmeabführungsfläche der Grundplatte 5 angepresst wird. Dabei wird das Kühlelement 6 flächig an die Wärmeabführungsfläche 52 der Grundplatte 5 angedrückt, so dass sich dessen Form der Unebenheit der Grundplatte 5 anpasst.

Allgemein sollte vorgesehen werden, dass das Kühlelement 6 flächig mit einer Kraft beaufschlagt wird, so dass über die gesamte Fläche der Grundplatte 5 ein Druck gegen die Grundplatte 5 ausgeübt wird, was z.B. auch durch alternative Mittel, wie einzelne Federelemente zwischen der Druckplatte 8 und einzelnen Abschnitten des Kühlelements 6 erreicht werden kann.

Die Druckplatte 8 ist im Wesentlichen starr ausgebildet und wird durch Bolzen 9 mit der Grundplatte 5 verbunden, so dass auf das elastische Material 7 über seine gesamte Fläche eine Kraft auf das Kühlelement 6 und somit auf die Wärmeabführungsfläche der Grundplatte 5 ausgeübt wird.

Das Kühlelement 6 ist mit der Wärmeabführungsfläche der Grundplatte 5 über ein wärmeleitfähiges Schnittstellenmaterial 53, wie z.B. eine Wärmeleitpaste verbunden, um die Wärmeübertragung von der Grundplatte 5 zum Kühlelement 6 weiter zu verbessern.

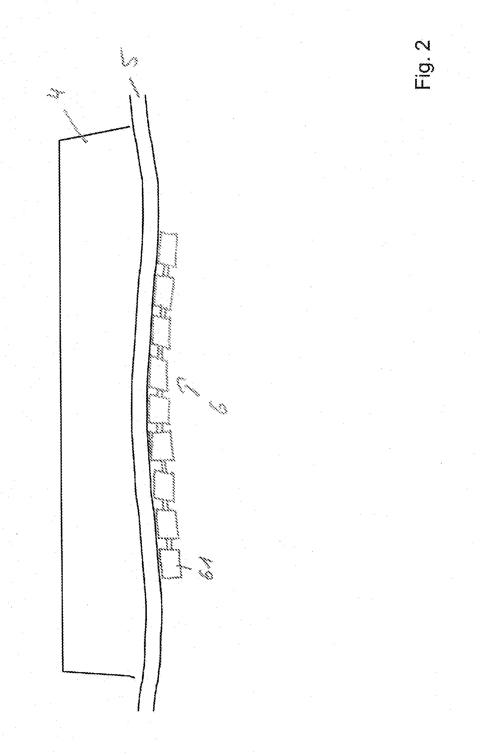

Das Kühlelement 6 weist vorzugsweise einzelne Kühlabschnitte 61 auf, die gegeneinander schwenkbar, z.B. über Stege 62 mit gegenüber den Kühlabschnitten 61 verringertem Querschnitt verbunden sind. In Fig. 2 ist ein solches Kühlelement 6 in einem Ausschnitt aus der Kühlanordnung 1 detaillierter dargestellt. Die Stege 62 sind so angeordnet, dass das Kühlelement 6 Schlitze 63 auf der der Wärmeabführungsfläche 52 zugewandten Seite aufweist. Durch diese Schlitze 63 kann zur Verbesserung der Kühlung ein Kühlmedium, wie z.B. Wasser oder Luft, geleitet werden.

Das Kühlelement 6 kann, wie in Fig. 1 ebenfalls dargestellt ist, mit einem Zuführungsanschluss 10 und mit einem Abführungsanschluss 11 ausgestattet sein, um ein Kühlmedium, wie z.B. Wasser oder Luft, durch innere, d.h. gegenüber der Grundplatte 5 und dem elastischen Material 7 getrennte Kühlmediumkanäle des Kühlelementes 6 zu leiten.

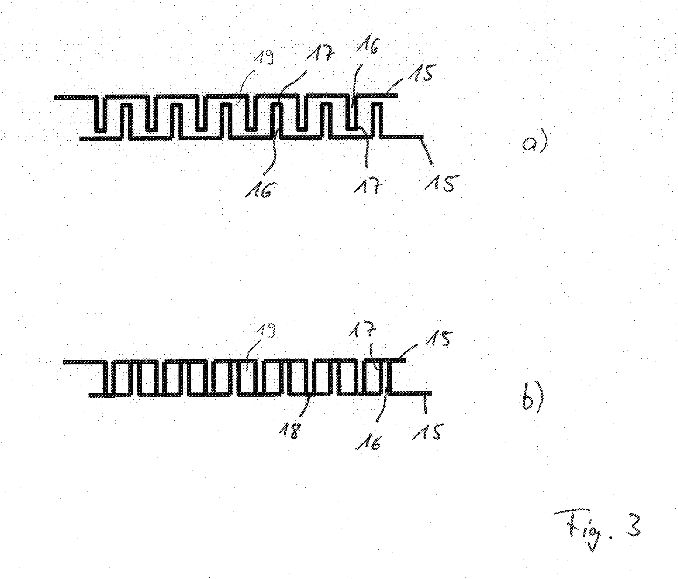

Die Ausführungsformen der Figuren 3 bis 6 zeigen detaillierter verschiedene Varianten zur Ausbildung der Kühlelemente 6 mit internen Kühlmediumkanälen zum Führen eines Kühlmediums.

Das Kühlelement 6 der Fig. 3a ist aus gleichartigen Kühlblechen 15, vorzugsweise aus einem metallischen, gut wärmeleitfähigen Material, wie z.B. Kupfer oder Aluminium, ausgebildet. Die Kühlbleche 15 weisen Verformungen in Form von grabenförmigen Vertiefungen 16 auf, die z.B. durch Prägen oder durch Tiefziehen hergestellt werden. Die Vertiefungen 16 entsprechen Vorsprüngen 17 auf den den grabenförmigen Vertiefungen 16 gegenüberliegenden Seite der Kühlbleche 15. Die grabenförmigen Vertiefungen 16 definieren gegeneinander verschwenkbare Kühlabschnitte 27, da im Bereich jeder Vertiefung die Verformbarkeit des Kühlelements 6 insbesondere die Schwenkbarkeit deutlich erhöht ist.

Beide Kühlbleche 15 können im Wesentlichen gleichartig ausgebildet sein und werden so aufeinander gesetzt, dass die Vorsprünge 17 der Kühlbleche 15 kammartig ineinander greifen, d.h. ein Vorsprung 17 eines der Kühlbleche 15 ragt kammartig in einen Zwischenraum zwischen zwei benachbarte Vorsprünge 17 des anderen Kühlbleches 15 hinein. Dadurch entstehen zwischen den beiden Kühlblechen 15 mäanderförmige Kühlmediumkanäle 19, durch ein Kühlmedium geleitet werden kann, um die aufgenommene Wärme abzuführen.

In dem Kühlelement 6 der Fig. 3a kontaktiert das jeweilige abstehende Ende der Vorsprünge 17 nicht das jeweils andere Kühlblech 15, so dass ein Durchlass zwischen den einzelnen Kühlabschnitten 27 verbleibt. So wird zwischen den beiden Kühlblechen 15 ein mäanderförmiger Kanal für das Kühlmedium in Längsrichtung der Flächenausdehnung der Kühlbleche 15 geschaffen.

Weiterhin ermöglichen die Vertiefungen 16 eine Querschnittsverkleinerung des gesamten Kühlelementes 6 an diesen Stellen, so dass dort eine Stelle erhöhter Biegsamkeit bzw. Verschwenkbarkeit des Kühlelementes 6 erreicht wird.

Die Abstände zwischen den grabenförmigen Vertiefungen 16 können über die Fläche des Kühlelements 6 identisch oder verschieden sein. Die Größe der zwischen den grabenförmigen Vertiefungen 16 gebildeten, gegeneinander verschwenkbaren Kühlabschnitte 27 sollte generell so gewählt werden, dass die Kühlabschnitte 27 des Kühlelements 6 mindestens mit einem Radius verschwenkt werden können, der gleich oder kleiner ist als der kleinstmögliche Radius, den die Grundplatte 5 aufgrund herstellungsbedingter Unebenheiten oder aufgrund von temperaturbedingten Verformungen aufweisen kann.

Bei dem Kühlelement 6 der Fig. 3b werden die kammartig gestanzten bzw. geprägten Kühlbleche 15 so weit miteinander verbunden, dass die abstehenden Enden der kammartigen Vorsprünge 17 an dem jeweils gegenüberliegenden Kühlblech anliegen bzw. mit diesem an einer Kontaktstelle 18 in Kontakt stehen. An der Kontaktstelle 18 können die beiden Kühlbleche 15 miteinander verlötet, z.B. durch Hartlöten, bzw. geklebt oder in sonstiger Weise dauerhaft miteinander verbunden werden.

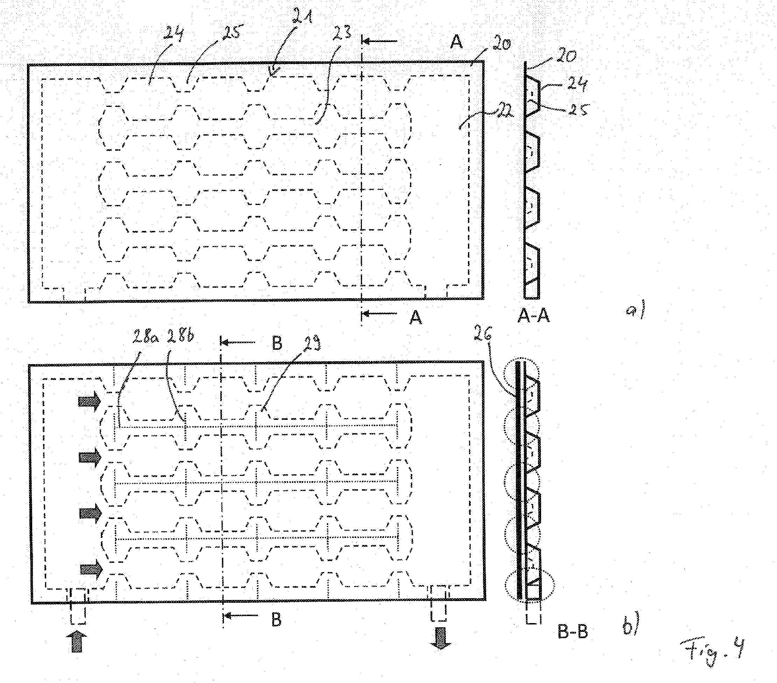

In den Figuren 4a und 4b sind schematisch eine Variante eines derartigen Kühlelementes 6 in Draufsicht und als Querschnittsansichten dargestellt. Fig. 4a zeigt eine Draufsicht auf eine Stanzform eines ersten Kühlbleches 20 und eine Querschnittsdarstellung entlang der Schnittlinie A-A. Fig. 4b zeigt das Kühlelement 6, das durch das erste Kühlblech und ein damit verbundenes zweites, im wesentlichen nicht verformtes Kühlblech 26 gebildet wird, in einer Draufsicht und in einer Querschnittsdarstellung entlang der Schnittlinie B-B.

In Fig. 4a ist das erste Kühlblech 20 aus einem metallischen Material dargestellt, in das z.B. durch Tiefziehen Kühlkanalstrukturen 21 eingebracht werden. Die Kühlkanalstrukturen 21 stellen Vertiefungen in dem ersten Kühlblech 20 dar. Die Kühlkanalstrukturen 21 schließen an Zu- bzw. Abführungsbereichsstrukturen 22 an, die ebenfalls als Vertiefungen ausgebildet sind.

Wie in Fig. 4a dargestellt ist, werden die Kühlkanalstrukturen 21 als im Wesentlichen längliche Vertiefungen zwischen Zu- bzw. Abführungsbereichsstrukturen 22 ausgebildet. Die Kühlkanalstrukturen 21 weisen entlang ihrer länglichen Erstreckung verschiedene Breiten (senkrecht zu ihrer länglichen Erstreckung, in einer Flächenrichtung des ersten Kühlbleches 20) auf.

Vorzugsweise werden entlang der Kühlkanalstrukturen 21 breitere und schmalere Vertiefungsstrukturen 24 bzw. 25 nacheinander vorgesehen. Dadurch wird eine erhöhte Verformbarkeit in Längsrichtung des durch die Kühlkanalstruktur 21 gebildeten Kühlkanals an den Bereichen der schmaleren Vertiefungsstrukturen 25 bereitgestellt.

Die nebeneinander angeordneten Kühlkanalstrukturen 21 sind also durch Bereiche voneinander getrennt, in denen das Material des ersten Kühlbleches 20 keine Vertiefung aufweist. Diese Bereiche werden als Trennbereiche 23 bezeichnet.

In Fig. 4b ist ein Kühlelement 6 dargestellt, bei dem das erste Kühlblech 20 der Fig. 4a mit einem zweiten ebenen Kühlblech 26 verbunden ist, z.B. aufgelötet, wie z.B. durch Hartlöten, aufgeklebt, geschweißt oder dergleichen. In diesem Fall sind im Wesentlichen diejenigen Bereiche, in denen das erste Kühlblech 20 keine Vertiefung, d.h. keine Kühlkanalstruktur 21 und keine Zu- bzw. Abführungsbereichsstruktur 22 aufweist, mit dem zweiten, nicht verformten, ebenen Kühlblech 26 fest verbunden. Durch die als Vertiefungen ausgebildeten Kühlkanalstrukturen 21 zwischen beiden Kühlblechen 20, 26 gebildeten Kühlmediumkanäle kann dann ein Kühlmedium geleitet werden, um die durch das Kühlelement 6 aufgenommene Wärme abzuführen. D.h. ein Kühlmedium, das in einen der Zu- bzw. Abführungsbereiche 22 geleitet wird, fließt durch die durch die Vertiefungen gebildeten Kühlkanäle zu dem jeweils anderen Zu- bzw. Abführungsbereich 22.

Um die Biegsamkeit bzw. Verformbarkeit eines so gebildeten Kühlelements 6 weiter zu verbessern, kann vorgesehen sein, in den Bereichen, an denen beide Kühlbleche 20, 26 miteinander verbunden sind, insbesondere in den Bereichen, die durch die Trennbereiche 23 definiert sind, Schlitze 28a, 28b vorzusehen, um den zu verformenden Querschnitt zu verringern. Die Schlitze 28a, 28b werden vorzugsweise in Bereichen eingebracht, an denen die beiden Kühlbleche 20, 26 mit-einander verbunden sind, so dass durch das Schneiden in die Trennbereiche 23 kein Leck in den Kühlmediumkanälen auftritt.

Alternativ oder zusätzlich können diese Bereichen durch Prägen oder Ritzen ganz oder teilweise verjüngt werden, z.B. durch einen Prägestempel. Dadurch wird der Querschnitt des Kühlelements 6 an diesen Stellen verringert. Auf diese Weise kann an den betreffenden Stellen eine besonders hohe Biegsamkeit bzw. Verformbarkeit erreicht werden.

Vorzugsweise werden die Schlitze 28a bzw. geprägten Bereiche in den Trennbereichen 23 längs zu den Kühlkanalstrukturen 21 bzw. den Kühlmediumkanälen vorgesehen. Alternativ oder zusätzlich können weitere Schlitze 28b bzw. geprägten Bereiche in Querrichtung dazu in den durch die schmaleren Vertiefungsstrukturen 25 gebildeten Ausbuchtungen 29 des Trennbereichs 23 zwischen den breiteren Vertiefungsstrukturen 24 vorgesehen werden, da sich bei einer Verformung des Kühlelementes 6 in Richtung der Flächennormalen der Kühlbleche 20, 26 und bezüglich der Längsrichtung L der Kühlmediumkanäle eine erhöhte Biegung des Kühlelementes 6 im Bereich der schmaleren Vertiefungsstrukturen 25 ergibt.

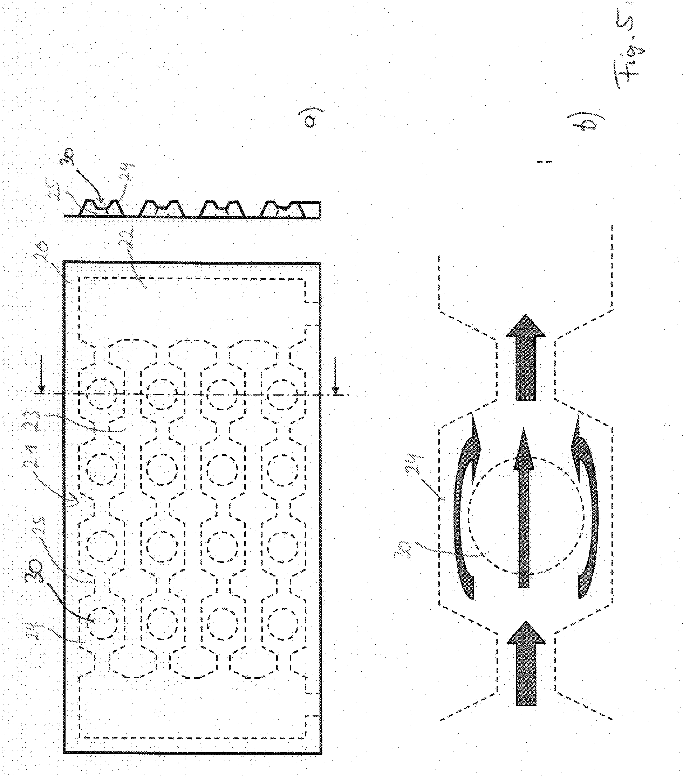

In Fig. 5a ist eine weitere Möglichkeit zur Ausbildung des strukturierten ersten Kühlbleches 20 dargestellt. Dabei weisen einer mehrere oder alle Bereiche der breiteren Vertiefungsstrukturen 24 Einbuchtungen 30 senkrecht und in Richtung zur Grundfläche des ersten Kühlbleches 20 vorzugsweise mit rundem, elliptischen oder eckigem Querschnitt auf, die zu einem entsprechenden Vorsprung in der jeweiligen Vertiefungsstrucktur 24 führen. Beim Zusammenfügen mit dem zweiten Kühlblech 26 ergeben sich Strömungskanäle, wobei in den durch die breiteren Vertiefungsstrukturen 24 gebildeten Abschnitten ein durch den der jeweiligen Einbuchtung 30 im ersten Kühlblech 20 entsprechenden Vorsprung ein Strömungshindernis für das Kühlmedium ausgebildet wird.

Ein Strömungsverlauf des Kühlmediums ist beispielsweise in Fig. 5b dargestellt, in der eine vergrößerte Ansicht eines durch die breitere Vertiefungsstruktur 24 gebildeten Abschnittes des Kühlmediumkanals dargestellt ist. Die Pfeile demonstrieren den Verlauf des Kühlmediums und deren Breite die Stärke der Strömung des Kühlmediums. Man erkennt, dass der Fluss des Kühlmediums im Bereich der Einbuchtung reduziert ist, so dass ein Teil des Kühlmediums um den durch die Einbuchtung 30 gebildeten Vorsprung herum fließen muss, so dass eine verbesserte Turbulenz des Kühlmediums innerhalb der Kühlkanäle erreicht wird. Dadurch kann eine bessere Abführung von Wärme erreicht werden.

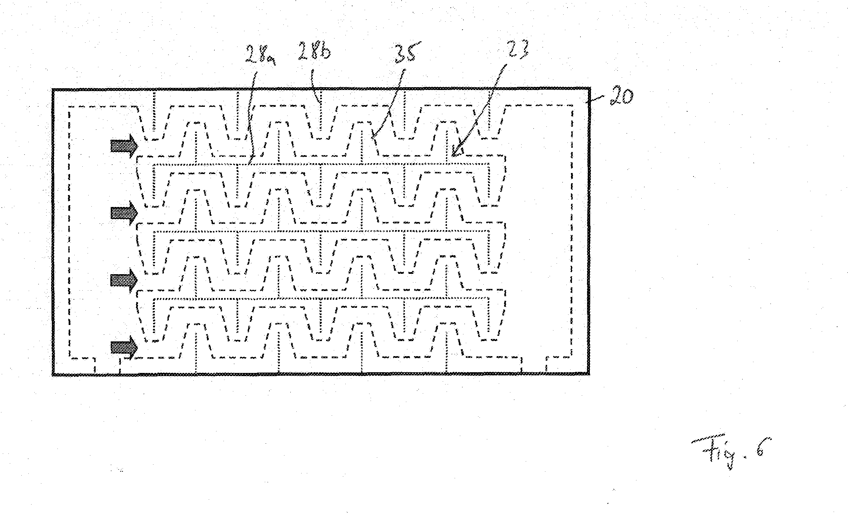

In Fig. 6 ist eine weitere Möglichkeit des Ausbildens der Kühlkanäle dargestellt. Im Gegensatz zu den Ausführungsformen der Fig. 4 und der Fig. 5 weist die Vertiefungsstruktur zum Ausbilden der Kühlkanäle eine im Wesentlichen gleiche Breite auf, wobei die Vertiefungsstruktur jedoch mäanderförmig über die Fläche der Kühlbleche 20, 26 verläuft. Wie bei Fig. 4 und Fig. 5 weist dadurch das mit den Kühlblechen 20, 26 gebildete Kühlelement 6 eine erhöhte Biegsamkeit in Richtung der Flächennormalen des Kühlelementes 6 und bezüglich einer Richtung senkrecht zur Längsrichtung der Kühlkanäle auf. Durch die mäanderförmige Struktur der Kühlkanäle wird weiterhin eine erhöhte Biegsamkeit in Richtung einer Flächennormalen des Kühlelementes 6 und bezüglich einer Längsrichtung der Kühlkanäle erreicht.

Die Biegsamkeit kann wie zuvor in Verbindung mit Fig. 4b beschrieben durch das Vorsehen von Schlitzen 28a, 28b und/oder nicht-durchgängigen Schritten und/oder Prägungen bzw. Ritzungen in den Bereichen erhöht, in denen die Kühlbleche 20, 26 miteinander verbunden sind.

Insbesondere können die Schlitze 28a, 28b und/oder die Prägungen bzw. Ritzungen in die durch die mäanderförmigen Struktur gebildeten Ausbuchtungen 35 des Trennbereichs 23 senkrecht zur Längsrichtung des Kühlkanals und in die Ausbuchtungen 35 des Trennbereiches 23 hineinreichend vorgesehen.

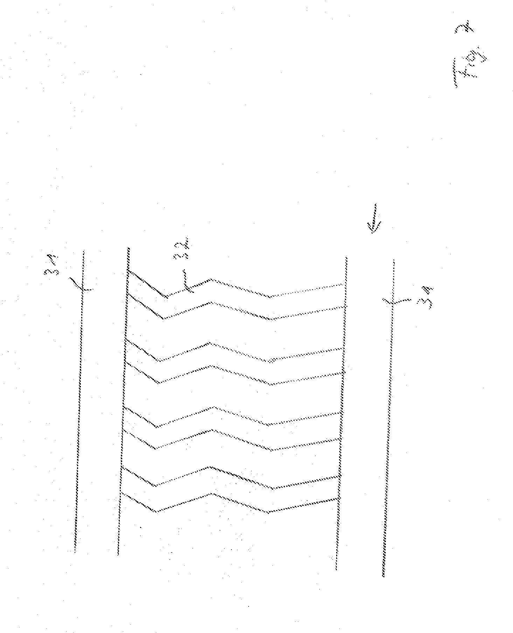

In Fig. 7 ist eine weitere Ausführungsform zur Ausbildung des Kühlelementes 6 dargestellt. Das Kühlelement der Fig. 7 umfasst Zu- bzw. Abführungselemente 31 zum Zu- bzw. Abführen eines Kühlmediums, wobei die Zu- bzw. Abführungselemente 31 über separate Kühlmediumkanäle, die als einzelne Kanalelemente 32 ausgebildet sind, miteinander verbunden werden, so dass ein Kühlmedium, das einem der Zu- bzw. Abführungselemente 31 zugeführt wird, durch die Kühlmedienkanäle der Kanalelemente 32 geleitet wird und über die weitere Zu- bzw. Abführungseinrichtung 31 abgeführt wird.

Die einzelnen Kanalelemente 32 sind voneinander als separate Bauelemente ausgebildet und weisen eine Fläche auf, die an der Wärmeabführungsfläche 52 der Grundplatte 5 anlegbar ist bzw. anliegt. Die Kanalelemente 32 können Teilabschnitte 33 aufweisen, die zueinander winklig angeordnet sind, um eine quasi mäanderförmige Struktur zu bilden. Dies ermöglicht eine erhöhte Biegsamkeit auch bezüglich der Längsrichtung jedes Kanalelementes 32.

### Bezugszeichenliste

1 Kühlanordnung
2 leistungselektronisches Bauelement
3 Kühlvorrichtung
4 Leistungsmodul
5 Grundplatte
6 Kühlelement
7 elastisches Material
8 Druckplatte
9 Bolzen
10 Zuführungsanschluss
11 Abführungsanschluss
15 Kühlfläche
16 grabenförmige Vertiefungen
17 Vorsprünge
18 Kühlmedium Kanäle
20 erstes Kühlblech
21 Kühlkanalstrukturen
22 Zu- bzw. Abführungsbereichstrukturen
23 Trennbereiche
24 breitere Vertiefungsstrukturen
25 schmalere Vertiefungsstrukturen
26 zweites Kühlblech
28a, 28b Schlitze
29 Ausbuchtungen
30 Einbuchtungen
31 Abzu- bzw. Abführungselemente
32 einzelne Kanalelemente
51 Befestigungsfläche
52 Wärmeabführungsfläche
61 Kühlabschnitte
62 Stiege
63 Schlitze

## Patentansprüche

1. Kühlelement (6) zum Abführen von Wärme von einem Wärme erzeugenden Bauelement (2), insbesondere einem leistungselektronischen Bauelement, wobei das Kühlelement (6) mehrere gegeneinander verschwenkbare Kühlabschnitte (61) mit jeweils einer Wärme aufnehmenden Teilfläche aufweist, wobei die Kühlabschnitte (61) gegeneinander verschwenkbar sind, so dass sich die Teilflächen an eine unebene Wärmeabführungsfläche (52) des Wärme erzeugenden Bauelements (2) anpassen.

2. Kühlelement (6) nach Anspruch 1 mit einem oder mehreren Kühlmediumkanälen durch mehrere der Kühlabschnitte (61), durch die ein Kühlmedium leitbar ist.

3. Kühlelement (6) nach Anspruch 2 mit einem ersten und einem zweiten Kühlblech (15, 20, 26) aus einem metallischen Material, die flächig aufeinander gefügt sind, wobei mindestens eines der Kühlbleche (15, 20, 26) Vertiefungen (16) aufweist, die beim Aufeinanderfügen in Richtung eines jeweils anderen Kühlbleches (15, 20, 26) weisen, so dass an der Stelle der Vertiefung (16) eine erhöhte Verschwenkbarkeit der zwischen den Vertiefungen (16) gebildeten Kühlabschnitte (61) besteht.

4. Kühlelement (6) nach Anspruch 3, wobei das erste und das zweite Kühlblech (15, 20, 26) Vorsprünge (17) aufweisen in die die Vertiefungen (16) hineinragen, wobei die Kühlbleche (15, 20, 26) so aufeinander gesetzt sind, dass die Vorsprünge (17) der Kühlbleche (15, 20, 26) gegeneinander gerichtet sind und kammartig ineinander greifen, so dass mindesten ein Vorsprung (17) des ersten Kühlblechs (20) zwischen zwei benachbarte Vorsprünge (17) des zweiten Kühlblechs (26) angeordnet ist.

5. Kühlelement (6) nach Anspruch 4, wobei ein Vorsprung (17) des ersten Kühlbleches (20) mit einem entsprechenden Bereich zwischen zwei Vorsprüngen (17) des zweiten Kühlbleches (26) verbunden ist.

6. Kühlelement (6) nach Anspruch 2, wobei das Kühlelement (6) durch flächiges Aufeinanderfügen von einem ersten und einem zweiten Kühlblech (15, 20, 26) aus einem metallischen Material gebildet ist, wobei mindestens das erste Kühlblech (20) so geformt ist, dass es in einem Kühlmediumkanalbereich, an dem der eine oder die mehreren Kühlmediumkanäle ausgebildet sind, bezüglich siner Grundflächevertieft ist.

7. Kühlelement (6) nach Anspruch 6, wobei mindestens einer der Kühlmediumkanäle Abschnitte mit verschiedenen Hauptfließrichtungen von Kühlmedium aufweist und insbesondere mäanderförmig ausgebildet ist.

8. Kühlelement (6) nach Anspruch 6 oder 7, wobei mindestens einer der Kühlmediumkanäle Abschnitte bezüglich der Querrichtung zu einer Hauptfließrichtung von Kühlmedium verschiedener Breite aufweist.

9. Kühlelement (6) nach einem der Ansprüche 6 bis 8, wobei zwischen den Kühlmediumkanälen des Kühlelements (6) Bereiche mit verringerter Dicke, insbesondere durchgängige Schlitze (28a, 28b) und/oder nicht-durchgängige Schnitte und/oder Prägebereiche, vorgesehen sind, um die Biegsamkeit senkrecht zu einer Flächenebene der Grundfläche des Kühlelements (6) zu erhöhen.

10. Kühlelement (6) nach Anspruch 9, wobei mindestens einer der Bereiche mit verringerter Dicke sich in einer ersten Flächenrichtung parallel zur Hauptfließrichtung der Kühlmediumkanäle, insbesondere zwischen zwei Kühlmediumkanälen erstrecken und/oder wobei die Bereiche mit verringerter Dicke sich in einer zweiten Flächenrichtung quer zur Hauptfließrichtung der Kühlmediumkanäle erstrecken.

11. Kühlvorrichtung (3) zum Abführen von Wärme von einem Wärme erzeugenden Bauelement (2), insbesondere einem leistungselektronischen Bauelement, umfassend:
- das Kühlelement (6) nach einem der Ansprüche 1 bis 10; und
- eine Anpresseinrichtung zum flächigen Ausüben einer Anpresskraft auf das Kühlelement.

12. Kühlvorrichtung (3) nach Anspruch 11, wobei die Anpresseinrichtung ein elastisches Material (7) aufweist, das mit Hilfe einer druckausübenden Einrichtung, insbesondere einer Druckplatte (8), gegen das Kühlelement (6) drückbar ist, um auf jeden Kühlabschnitt (61) des Kühlelementes (6) die Anpresskraft auszuüben.

13. Kühlvorrichtung (3) nach Anspruch 11, wobei die Anpresseinrichtung eine Druckkammer aufweist, die so mit dem Kühlelement (6) verbunden ist, dass durch Einbringen eines erhöhten Druck in der Druckkammer die Anpresskraft flächig auf das Kühlelement (6) wirkt, um auf jeden Kühlabschnitt (61) des Kühlelementes (6) die Anpresskraft auszuüben.

14. Kühlanordnung (1) mit einem Wärme erzeugenden Bauelement und einer Kühlvorrichtung (3) nach einem der Ansprüche 11 bis 13.

## Geänderte Patentansprüche

### Geänderte Patentansprüche gemäss Regel 137(2) EPÜ.

**1.** Kühlelement (6) zum Abführen von Wärme von einem Wärme erzeugenden Bauelement (2), insbesondere einem leistungselektronischen Bauelement,
wobei das Kühlelement (6) mehrere gegeneinander verschwenkbare Kühlabschnitte (61) mit jeweils einer Wärme aufnehmenden Teilfläche aufweist und die Kühlabschnitte (61) gegeneinander verschwenkbar sind, so dass sich die Teilflächen an eine unebene Wärmeabführungsfläche (52) des Wärme erzeugenden Bauelements (2) anpassen,
mit einem oder mehreren Kühlmediumkanälen durch mehrere der Kühlabschnitte (61), durch die ein Kühlmedium leitbar ist und mit einem ersten und einem zweiten Kühlblech (15, 20, 26) aus einem metallischen Material, die flächig aufeinander gefügt sind, wobei mindestens eines der Kühlbleche (15, 20, 26) Vertiefungen (16) aufweist, die beim Aufeinanderfügen in Richtung eines jeweils anderen Kühlbleches (15, 20, 26) weisen, so dass an der Stelle der Vertiefung (16) eine erhöhte Verschwenkbarkeit der zwischen den Vertiefungen (16) gebildeten Kühlabschnitte (61) besteht, **dadurch gekennzeichnet,**
**dass** das erste und das zweite Kühlblech (15, 20, 26) Vorsprünge (17) aufweisen in die die Vertiefungen (16) hineinragen, wobei die Kühlbleche (15, 20, 26) so aufeinander gesetzt sind, dass die Vorsprünge (17) der Kühlbleche (15, 20, 26) gegeneinander gerichtet sind und kammartig ineinander greifen, so dass mindesten ein Vorsprung (17) des ersten Kühlblechs (20) zwischen zwei benachbarte Vorsprünge (17) des zweiten Kühlblechs (26) angeordnet ist.

**2.** Kühlelement (6) zum Abführen von Wärme von einem Wärme erzeugenden Bauelement (2), insbesondere einem leistungselektronischen Bauelement,
wobei das Kühlelement (6) mehrere gegeneinander verschwenkbare Kühlabschnitte (61) mit jeweils einer Wärme aufnehmenden Teilfläche aufweist und die Kühlabschnitte (61) gegeneinander verschwenkbar sind, so dass sich die Teilflächen an eine unebene Wärmeabführungsfläche (52) des Wärme erzeugenden Bauelements (2) anpassen,
mit einem oder mehreren Kühlmediumkanälen durch mehrere der Kühlabschnitte (61), durch die ein Kühlmedium leitbar ist, **dadurch gekennzeichnet,**
**dass** das Kühlelement (6) durch flächiges Aufeinanderfügen von einem ersten und einem zweiten Kühlblech (15, 20, 26) aus einem metallischen Material gebildet ist,
wobei mindestens das erste Kühlblech (20) so geformt ist, dass es in einem Kühlmediumkanalbereich, an dem der eine oder die mehreren Kühlmediumkanäle ausgebildet sind, bezüglich seiner Grundfläche vertieft ist.

**3.** Kühlelement (6) nach Anspruch 1, **dadurch gekennzeichnet, dass** ein Vorsprung (17) des ersten Kühlbleches (20) mit einem entsprechenden Bereich zwischen zwei Vorsprüngen (17) des zweiten Kühlbleches (26) verbunden ist.

**4.** Kühlelement (6) nach Anspruch 2, **dadurch gekennzeichnet, dass** mindestens einer der Kühlmediumkanäle Abschnitte mit verschiedenen Hauptfließrichtungen von Kühlmedium aufweist und insbesondere mäanderförmig ausgebildet ist.

**5.** Kühlelement (6) nach Anspruch 2 oder 4, **dadurch gekennzeichnet, dass** mindestens einer der Kühlmediumkanäle Abschnitte bezüglich der Querrichtung zu einer Hauptfließrichtung von Kühlmedium verschiedener Breite aufweist.

**6.** Kühlelement (6) nach einem der Ansprüche 2, 4 oder 5, **dadurch gekennzeichnet, dass** zwischen den Kühlmediumkanälen des Kühlelements (6) Bereiche mit verringerter Dicke, insbesondere durchgängige Schlitze (28a, 28b) und/oder nichtdurchgängige Schnitte und/oder Prägebereiche, vorgesehen sind, um die Biegsamkeit senkrecht zu einer Flächenebene der Grundfläche des Kühlelements (6) zu erhöhen.

**7.** Kühlelement (6) nach Anspruch 6, **dadurch gekennzeichnet, dass** mindestens einer der Bereiche mit verringerter Dicke sich in einer ersten Flächenrichtung parallel zur Hauptfließrichtung der Kühlmediumkanäle, insbesondere zwischen zwei Kühlmediumkanälen erstrecken und/oder wobei die Bereiche mit verringerter Dicke sich in einer zweiten Flächenrichtung quer zur Hauptfließrichtung der Kühlmediumkanäle erstrecken.

**8.** Kühlvorrichtung (3) zum Abführen von Wärme von einem Wärme erzeugenden Bauelement (2), insbesondere einem leistungselektronischen Bauelement, umfassend:
- das Kühlelement (6) nach einem der Ansprüche 1 bis 7; und
- eine Anpresseinrichtung zum flächigen Ausüben einer Anpresskraft auf das Kühlelement.

**9.** Kühlvorrichtung (3) nach Anspruch 8, wobei die Anpresseinrichtung ein elastisches Material (7) aufweist, das mit Hilfe einer druckausübenden Einrichtung, insbesondere einer Druckplatte (8), gegen das Kühlelement (6) drückbar ist, um auf jeden Kühlabschnitt (61) des Kühlslementes (6) die Anpresskraft auszuüben.

**10.** Kühlvorrichtung (3) nach Anspruch 8, wobei die Anpresseinrichtung eine Druckkammer aufweist, die so mit dem Kühlelement (6) verbunden ist, dass durch Einbringen eines erhöhten Druck in der Druckkammer die Anpresskraft flächig auf das Kühlelement (6) wirkt, um auf jeden Kühlabschnitt (61) des Kühlelementes (6) die Anpresskraft auszuüben.

**11.** Kühlanordnung (1) mit einem Wärme erzeugenden Bauelement und einer Kühlvorrichtung (3) nach einem der Ansprüche 8 bis 10.
